# EUROPEAN PATENT APPLICATION

(11) **EP 2 077 586 A1**
(43) Date of publication of application: **08.07.2009**
(21) Application number: 06822086.2
(22) Date of filing: 24.10.2006
(51) Int. Cl.: H01L 31/042

(54) **CONCENTRATING PHOTOVOLTAIC APPARATUS**

(71) Applicant: Daido Steel Co.,Ltd., Nagoya-shi Aichi 461-8581 (JP)
(72) Inventor: ARAKI, Kenji, Nagoya-shi Aichi 461-8581 (JP); YANO, Taizo, Nagoya-shi Aichi 461-8581 (JP); UOZUMI, Hisafumi, Nagoya-shi Aichi 461-8581 (JP)
(74) Representative: TBK-Patent
(86) International application number: PCT/JP2006/321106
(87) International publication number: WO 2008/050392

(57) **Abstract**

SUBJECT

To provide a concentrator solar photovoltaic power generating apparatus with high durability and little deterioration of a transparent resin by light.

MEANS FOR SOLUTION

In the concentrator solar photovoltaic power generating apparatus 10, since the white resin member (shielding member) 64 to shield the transparent resin member 62 interposed between the bottom end surface of the homogenizer (columnar optical member) 50 and the solar cell 34 is provided, the bonded surface is not damaged due to deterioration of the transparent resin member 62 by light and, consequently, deterioration of the solar cell 34 due to entering moisture is restrained and high durability of the concentrator solar photovoltaic power generating apparatus 10 is achieved. Since the white resin member (shielding member) 64 is non-transparent colored resin member covering the transparent resin member 62, the white resin member 64 prevents deterioration of the transparent resin member 62 by sunlight, for the sunlight is difficult to reach the transparent resin member 62.

## Description

### TECHNICAL FIELD

The present invention relates to a concentrator solar photovoltaic power generating apparatus in which sunlight is focused by a primary optics onto a small but highly efficient solar cell, particularly, to technique to provide the apparatus with high durability.

### BACKGROUND ART

The concentrator solar photovoltaic power generating apparatus draws public attention. Sunlight can be collected from a large area using cheap materials, such as plastic, but the power conversion is performed by a high performance solar cell (as disclosed, for example, in Non-Patent Document 1 described below). In this apparatus, the concentrated light that is concentrated in the primary optics has unevenness in its intensity, such as high intensity in its center and low intensity in its surroundings. Non-Patent Document 2, for example, points out that, consequently, direct irradiation to the solar cell with the concentrated light that is concentrated in the primary optics causes reduction in power generation efficiency. Then, Non-Patent Document 2 described below suggests a secondary optics in which the concentrated light that is concentrated in the primary optics is repeatedly reflected on the side face and mixed (as disclosed, for example, in Non-Patent Document 2).
Non-Patent Document 1: "Development of concentrator type solar photovoltaic power generating apparatus performing 28% in conversion efficiency", Araki et al., Electric Steel Making, July 2004, Vol. 75, No. 3, pp. 165-172.
Non-Patent Document 2: "Development of secondary optics for concentrator type solar photovoltaic power generating apparatus", Araki et al., Electric Steel Making, October 2002, Vol. 73, No. 4, pp. 221-228.

### DISCLOSURE OF THE INVENTION

### SUBJECT TO BE SOLVED

Moisture due to dew formation in the housing of the concentrator solar photovoltaic power generating apparatus described above at night, causes further deterioration of solar cells. In the solar cell constituted, especially, by a compound semiconductor of groups III-V such as InGaP/InGaAs/Ge, the material is extremely deteriorated by moisture because the material of it is more active than that of the solar cells constituted by a crystalline silicon semiconductor. To avoid deterioration of the solar cell, a transparent resin is interposed between the solar cell and the bottom end surface of a columnar optical member included in the above-indicated secondary optics, or a protection layer is provided on the surface of the solar cell.

However, it is found there are disadvantages, for example, as follows. (a) The above-indicated transparent resin formed of a material having superior optical characteristics such as silicone resin or epoxy resin, cannot avoid being deteriorated due to travel of sunlight having high energy through the transparent material. (b) A thick wiring ribbon to which a comparatively large current is applied is connected to the solar cell, and it is difficult that the thick wiring ribbon is sufficiently sealed with the sealing resin such as the above-indicated transparent resin. (c) As a result, the moisture enters a gap between a micro comb-shaped electrode and the cell, advances along the gap to the center of the cell due to the capillarity, and causes the anti-reflection coating on the surface of the cell to be deliquesced, damaging the bonded surface. (The gap is generated at the concave/convex portion of the comb-shaped electrode, and caused by the damage on the bonded surface of the above-indicated silicone resin or epoxy resin due to deterioration by light and the difference of coefficients of thermal expansion.)

A sign of deliquescence of the anti-reflection coating (such as ZnS/MgF₂) on the surface of the solar cell can be easily observed, in the moist environment due to dew formation at a lower temperature than the air temperature for twenty-four hours or even in an outdoor practical test for about a month.

The present invention was made in the light of the background art described above. It is an object of the present invention to provide a concentrator solar photovoltaic power generating apparatus with high durability and little deterioration of a transparent resin by light.

### MEANS FOR SOLVING THE SUBJECT

The object indicated above may be achieved according to a first aspect of the invention, which provides a concentrator solar photovoltaic power generating apparatus including a primary optics for concentrating sunlight, a solar cell, a columnar optical member which is vertically disposed above the solar cell so that a bottom end surface of the columnar optical member is opposed to the solar cell, and which is used for guiding the sunlight which is concentrated by the primary optics to the solar cell, a transparent resin member which is interposed between the bottom end surface of the columnar optical member and the solar cell, being characterized by comprising a shielding member for shielding the transparent resin member from sunlight.

The object indicated above may be achieved according to a second aspect of the invention, which provides the apparatus as defined in the first aspect of the present invention, being characterized by that the shielding member is a non-transparent colored resin member which covers the transparent resin member.

The object indicated above may be achieved according to a third aspect of the invention, which provides the apparatus as defined in the second aspect of the present invention, being characterized by that the non-transparent colored resin member is a white resin member including filler which is constituted by white and non-transparent powder, and is disposed so as to cover an outer circumferential surface of a bottom end portion of the columnar optical member.

The object indicated above may be achieved according to a fourth aspect of the invention, which provides the apparatus as defined in any one of the first to third aspects of the present invention, being characterized by that the solar cell is provided with an anti-reflection layer of TiO₂/Al₂O₃ at its light receiving surface.

The object indicated above may be achieved according to a fifth aspect of the invention, which provides the apparatus as defined in the first aspect of the present invention, being characterized by that the shielding member covers a bottom end portion of the columnar optical member and the solar cell which is opposed to a bottom end surface of the columnar optical member, and includes not less than 10 wt% of fluorosilicone resin.

The object indicated above may be achieved according to a sixth aspect of the invention, which provides the apparatus as defined in the fifth aspect of the present invention, being characterized by that the shielding member includes not more than 50 wt% of fluorosilicone resin.

The object indicated above may be achieved according to a seventh aspect of the invention, which provides the apparatus as defined in any one of the first to sixth aspects of the present invention, being characterized by that the shielding member has a permeability rate of not more than 50 g/m² ·24h.

The object indicated above may be achieved according to a eighth aspect of the invention, which provides the apparatus as defined in any one of the first to eighth aspects of the present invention, being characterized by that the transparent resin member is interposed between the bottom end surface of the columnar optical member and the solar cell, and the shielding member is constituted by a non-transparent colored silicone resin member including filler.

The object indicated above may be achieved according to a ninth aspect of the invention, which provides the apparatus as defined in any one of the first to eighth aspects of the present invention, being characterized by that the columnar optical member is constituted by borosilicate glass.

The object indicated above may be achieved according to a tenth aspect of the invention, which provides the apparatus as defined in any one of the first to ninth aspects of the present invention, being characterized by that glass which constitutes the columnar optical member has not larger than 10 nm of the surface roughness Ra (arithmetic averaged roughness).

### EFFECT OF THE INVENTION

In the concentrator solar photovoltaic power generating apparatus according to the first aspect of the invention, since it is provided with the transparent resin member which is interposed between the bottom end surface of the columnar optical member and the solar cell, and the shielding member for shielding the transparent resin member from sunlight, the bonded surface is not damaged due to deterioration of the transparent resin member by light, and consequently, deterioration of the solar cell due to entering moisture is restrained and high durability of the concentrator solar photovoltaic power generating apparatus is achieved.

In the apparatus according to the second aspect of the invention, since the shielding member is the non-transparent colored resin member which covers the transparent resin member, the non-transparent colored resin member prevents deterioration of the transparent resin member by sunlight that is difficult to reach the transparent resin member.

In the apparatus according to the third aspect of the invention, since the non-transparent colored resin member is the white resin member including the filler which is constituted by the white and non-transparent powder, and is disposed so as to cover the outer circumferential surface of the bottom end portion of the columnar optical member, the sunlight directing outwards through the outer surface in the bottom end portion of the columnar optical member is reflected by a plurality of times and reach the solar cell, and consequently, further higher generation efficiency is achieved. Especially, a remarkable effect as described above is observed in the case of sunlight which is entered the columnar optical member at a larger incident angle with respect to the incident surface.

In the apparatus according to the fourth aspect of the invention, since the solar cell is provided with the anti-reflection layer of TiO₂/Al₂O₃ at its light receiving surface, the anti-reflection layer is constituted of a material without deliquescence, further high durability of the concentrator solar photovoltaic power generating apparatus is achieved.

In the apparatus according to the fifth aspect of the invention, since the shielding member covers a bottom end portion of the columnar optical member and the solar cell which is opposed to a bottom end surface of the columnar optical member, and includes not less than 10 wt% of fluorosilicone resin, the low moisture permeation characteristic of fluorosilicone resin restrains entering of water vapor (or moisture), and consequently, it causes high durability and low deterioration in generation efficiency.

In the apparatus according to the sixth aspect of the invention, since the shielding member includes not more than 50 wt% of fluorosilicone resin, the low moisture permeation characteristic of fluorosilicone resin restrains entering of water vapor (or moisture), and consequently, it causes high durability and low deterioration in generation efficiency for the concentrator solar photovoltaic power generating apparatus at low cost. Adding more than 50 wt% of fluorosilicone resin causes substantially no further advantage in its effect and a rise of the cost due to an addition of waste expensive material.

In the apparatus according to the seventh aspect of the invention, since the shielding member has a permeability rate of not more than 50 g/m² ·24h, entering of moisture is restrained, and consequently, it causes high durability and low deterioration in generation efficiency.

In the apparatus according to the eighth aspect of the invention, since a transparent resin member is interposed between the bottom end surface of the columnar optical member and the solar cell, and the shielding member is constituted by the non-transparent colored silicone resin member including a filler, the solar cell is shielded and preferably protected from the external light.

In the apparatus according to the ninth aspect of the invention, since the columnar optical member is constituted by superior chemically stable and waterproof borosilicate glass, a little amount of sodium component in the columnar optical member is eluted upon reaching of water vapor on the surface of the columnar optical member, and consequently, it causes high durability and low deterioration in generation efficiency.

In the apparatus according to the tenth aspect of the invention, since glass which constitutes the columnar optical member has not larger than 10 nm of the surface roughness Ra (arithmetic averaged roughness), a high reflection factor of the internal side surface of the columnar optical member is provided, and consequently, it causes high generation efficiency. Preferably, the glass which constitutes the columnar optical member has not larger than 2 nm of the surface roughness Ra and it causes higher generation efficiency.

Preferably, the transparent resin member is made of a material having superior optical characteristics such as silicone gel. Other material may be also employed.

A material which has ability to bond the transparent resin member, the columnar optical member and the solar cell together is selected for the non-transparent colored resin member. An inorganic material having high thermal conductivity and light reflection such as calcium carbonate, titanium oxide, high purity alumina, short chain magnesium oxide, beryllium oxide and/or aluminum nitride is preferably employed for the filler constituted by the white and non-transparent powder included in the white resin member functioning as the non-transparent colored resin member. An adhesive assistant such as silane coupling agent is appropriately mixed into the white resin member for increasing of adhesion.

A metal thin layer covering the transparent member may be employed for the shielding member, or a non-transparent colored resin member which may be employed. The non-transparent colored resin for the non-transparent colored resin member is non-transparent resin that is colored such as white or black by mixing a coloring pigment into the base resin, and then, through which light cannot travel. Preferably, such as acrylic resin, polyester resin, self-adhesive RTV (Room Temperature Vulcanizing) silicone resin or epoxy resin is employed for the base resin. Especially, self-adhesive RTV silicone resin is most preferable in view of light resistance, heat resistance and self-adhesion.

The solar cell is a chip constituted by the compound semiconductor of groups III-V to which metal wiring ribbons are connected at their end portions. Even thus the solar cell is constituted by comparatively fairly active material, and even it is comparatively difficult to seal the solar cell including their end portions to which the metal wiring ribbons are connected, further high durability in the concentrator solar photovoltaic power generating apparatus is achieved.

The metal wiring ribbons are electrically connected to the solar cell at their end portions on the surface and the bottom surface by soldering or brazing. A material having low resistance, high thermal conductivity and humidity stability is employed for the metal wiring ribbon which is a thin metal plate of a tape-like shape having a predetermined width. For example, oxygen-free copper, a laminated plate of copper/aluminum nitride/copper, a laminated plate of copper/aluminum oxide/copper or a laminated plate of copper/tin/solder is preferably employed.

The condenser lens such as a Fresnel lens may be employed for the primary optics, or a concentrator reflecting mirror which concentrates sunlight by reflecting off a mirror such as a concave mirror may be employed.

The columnar optical member functions as the secondary optics, and is a columnar dielectric which homogenizes in energy the concentrated sunlight that is entered into its upper end surface by utilizing the total reflection in the traveling process, and directs and enters the solar cell disposed opposing to the bottom end surface with a slight distance therebetween. Glass which has high optical transmission properties is preferably employed, and especially, soda lime glass which is general-purpose, low-cost and easy-processing, and borosilicate glass which has superior optical characteristics are extensively and frequently employed. And such as aluminosilicate glass or soda potash barium glass are employed in a severe environment. The conventional optics having a square-shaped cross section that is parallel to the incident surface or output surface is well-known for the secondary optics. Furthermore, another optics having another shape, such as a quadrangle other than a square, a polygon other than a quadrangle, a circle or other variations, of the cross section may be employed. Although it is preferable that the secondary optics has a cross section such that the area of the cross section becomes smaller as approaching the output surface side, that is, a taper shape, the system having the uniform area of the cross section in every point in the longitudinal direction may be also available.

The columnar optical member may be provided on the upper end surface with a monolayer or multilayer of a magnesium fluoride layer and/or a calcium fluoride layer which is conventionally used for optical lenses, for the anti-reflection layer. Further to a vacuum evaporation method (and not limited to the vacuum evaporation method), various conventional manners may be employed for providing with the anti-reflection layer. For the secondary optics having the anti-reflection layer on its incident surface, the system having a protection member in a layer (or film) state, that is, a protection layer, laminated on the anti-reflection layer may be available, contrarily, the system having the anti-reflection layer laminated on a protection layer may be also available. Another system having no protection layer on the incident surface may be available.

The structure of the bilayer or multilayer of alumina (Al₂O₃) and titania (TiO₂) is preferable for the anti-reflection layer in order to prevent from deterioration due to moisture, and other materials such as calcium fluoride, magnesium fluoride and/or zinc sulfide is also available.

Preferably, the corner portions, that is, four corners of the columnar optical member are chamfered by a predetermined curvature radius, and the chamfered surfaces are planished. Consequently, protection from chipping at the corner portion is expected and leakage of light is preferably restrained to increase generation efficiency.

Preferably, the side (wall) surface of the columnar optical member is textured (in a texturing process). In the texturing, many fine projections and dents, or many fine longitudinal ridges (or swells) or grooves are made in laser processing, processing the surface by laser light, in buffing (processing) with free abrasive grains, or in polishing (processing) by a grindstone having fixed abrasive grains or by a coated abrasives. While the projections, dents, ridges and grooves are preferably longitudinally formed, they may be formed to extend in the direction having the same directional component as the longitudinal direction of the columnar optical member, for example, to extend in the oblique direction, or to extend in the oblique directions crossing each other, namely, so that a mesh-like ridges or grooves are formed.

### BRIEF DESCRIPTION OF THE DRAWINGS

Fig. 1 illustrates a concentrator solar photovoltaic power generating apparatus according to one embodiment of the present invention which a sun tracking apparatus is furnished with, in a perspective view.
Fig. 2 illustrates the concentrator solar photovoltaic power generating apparatus in Fig. 1 from the side direction in a perspective view.
Fig. 3 illustrates a part of the apparatus in Fig. 2 in an enlarged view.
Fig. 4 illustrates a generation module of the apparatus in Fig. 1 which comprises a plurality of generation modules disposed within in an enlarged cross sectional view.
Fig. 5 illustrates the homogenizer in which the sunlight travels repeating the internal total reflection on the interface.
Fig. 6 illustrates changes in relative amounts of power generation that were measured under concentrated ultraviolet radiation corresponding to the accumulated amount for exposure for the not less than 20-year equivalence in the positively induced dew formation environment at the temperature of 20°C by water cooling, with respect to the generation module C equal to that in Fig. 4, and the generation module A equal to the module B having the transparent silicone resin member by which the white resin member is replaced.
Fig. 7 illustrates characteristics of a decrease in the relative generation amount measured of the solar cell that were removed from a plurality of generation modules A in which the solar cell and the transparent resin member is sealed with a conventional silicone resin member after exposed to the outdoor for four months.
Fig. 8 illustrates the result of the field test in the outdoor using a plurality of the generation module A in which the solar cell and the transparent resin member is sealed with a conventional silicone resin member, and the generation module C provided with the white resin member and anti-reflection layer equivalent to those in the embodiment in Fig. 4.
Fig. 9 illustrates the results indicated by a relative output value, of an accelerating environment test for a plurality of kinds of samples equivalent to the generation modules in Fig. 4 in which a mixture rate of fluorosilicone resin in the white resin member is changed.
Fig. 10 illustrates the results indicated by a relative value, of the generation output using generation module samples having the homogenizer constituted by glass having different surface roughness
Fig. 11 illustrates a structure of the generation module of another embodiment according to the present invention.
Fig. 12 illustrates a structure of the generation module of another embodiment according to the present invention.

### LIST OF COMPONENTS

- 10:: Concentrator solar photovoltaic power generating apparatus
- 28:: Condenser lens (Primary optics)
- 34:: Solar cell
- 50:: Homogenizer (Secondary optics, Columnar optical member)
- 52:: Anti-reflection layer
- 62:: Transparent resin member
- 54:: White resin member (Shielding member)

### BEST MODE FOR CARRYING OUT THE INVENTION

The preferred embodiments of this invention will be described in detail by reference to the accompanying drawings. The figures are appropriately simplified or transformed, and all the proportion of the dimension and the shape of a portion or member are not reflective of the real one in the following embodiments.

### Embodiment 1

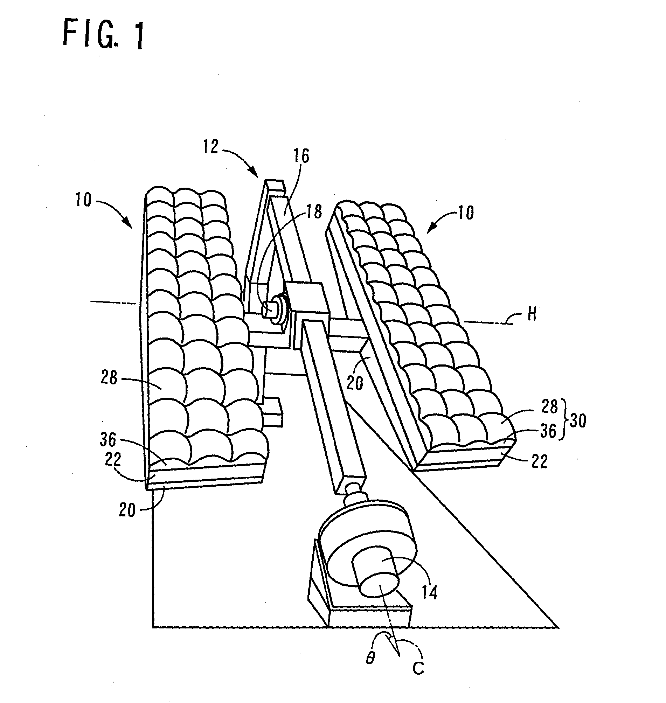

Fig. 1 illustrates a concentrator solar photovoltaic power generating apparatus 10 according to one embodiment of the present invention which a sun tracking apparatus 12 is furnished with, in a perspective view. The sun tracking apparatus 12 is configured to move and constantly direct the apparatus 10 to the sun. The apparatus 12 includes a tracking motor 14, an inclined beam 16, an altitude correction motor 18 and a pair of backing plates 20. The inclined beam 16 is rotatably mounted around an inclined axis C which is inclined by a predetermined angle θ, namely, an angle corresponding to the latitude, from the horizontal plane so that the beam 16 is placed and extends parallel to the earth's axis. And the tracking motor 14 with a reduction gear changes the rotation angle of the inclined beam 16 around the inclined axis C. The backing plates 20 are rotatably mounted around the horizontal axis H at the intermediate portion of the inclined beam 16. And the altitude correction motor 18 changes the rotation angle of the backing plates 20 around the horizontal axis H. The apparatus 10 has a shape of a long box which has substantially greater dimensions in the longitudinal and lateral directions with respect to the height (or thickness). Each of the apparatus 10 is respectively placed upon and secured to the pair of the backing plates 20.

The above-indicated sun tracking apparatus 12 is provided with a sunlight sensor and a control device (not shown). The control device calculates and determines the position of the sun on the basis of the signal from the sunlight sensor. Then the apparatus 12 drives the tracking motor 14 and the altitude correction motor 18 so that the apparatus 12 directs the concentrator solar photovoltaic power generating apparatus 10 to the sun, that is, a light receiving surface of the apparatus 10 faces toward the sun so that the axis of incidence of the sunlight is always substantially perpendicular to the light receiving surface of the apparatus 10. The tracking motor 14 is substantially employed for tracking control of the movement of the sun from the sunrise to the sunset, reflective of the rotation of the earth. And the altitude correction motor 18 is substantially employed for control of the movement of the sun in the altitude direction, reflective of the revolution of the earth.

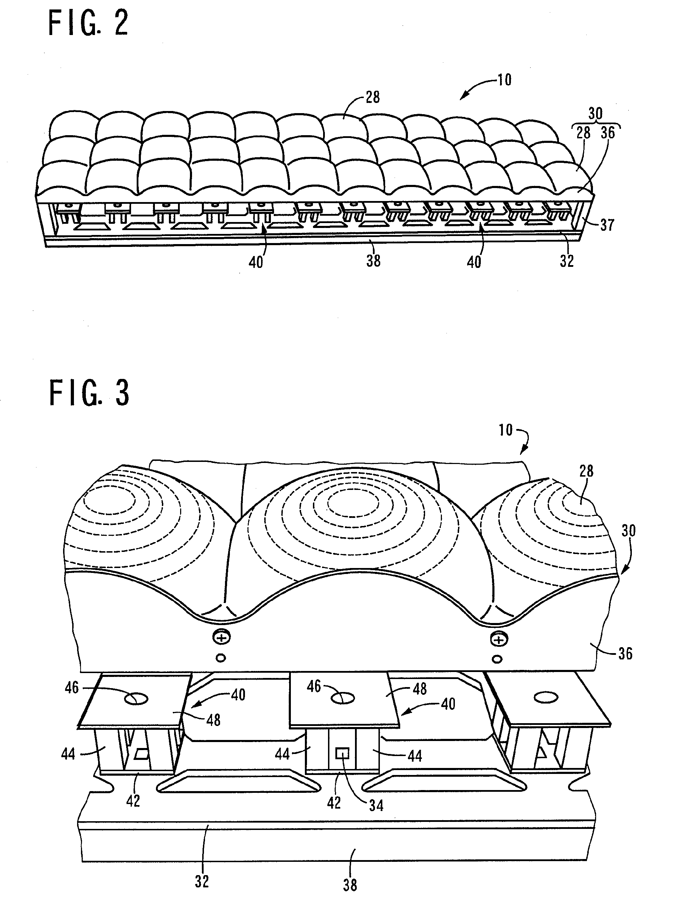

Fig. 2 illustrates the above-indicated concentrator solar photovoltaic power generating apparatus 10 from the side direction in a perspective view. Fig. 3 illustrates a part of the apparatus 10 in an enlarged view. In Figs. 2 and 3 a side plate 22 is removed from the apparatus 10 to show the internal structure. The apparatus 10 comprises a concentrator plate 30, a support plate 32 and a plurality of solar cell 34. The concentrator plate 30 is provided with a plurality of condenser lenses (or concentrator lenses) 28 functioning as a primary optical system or primary optics. The plate 30 in this embodiment has 36 condenser lenses. The support plate 32 is spaced backwards by a predetermined distance from the concentrator plate 30 and fixed parallel to the concentrator plate 30. Each of the respective solar cell 34 is disposed in the respective receiving position on which the cell 34 respectively receive the sunlight concentrated by each of a plurality of the above-indicated condenser lens 28 on the support plate 32. A reinforcing plate 38 is fixed on the periphery of the back of the support plate 32.

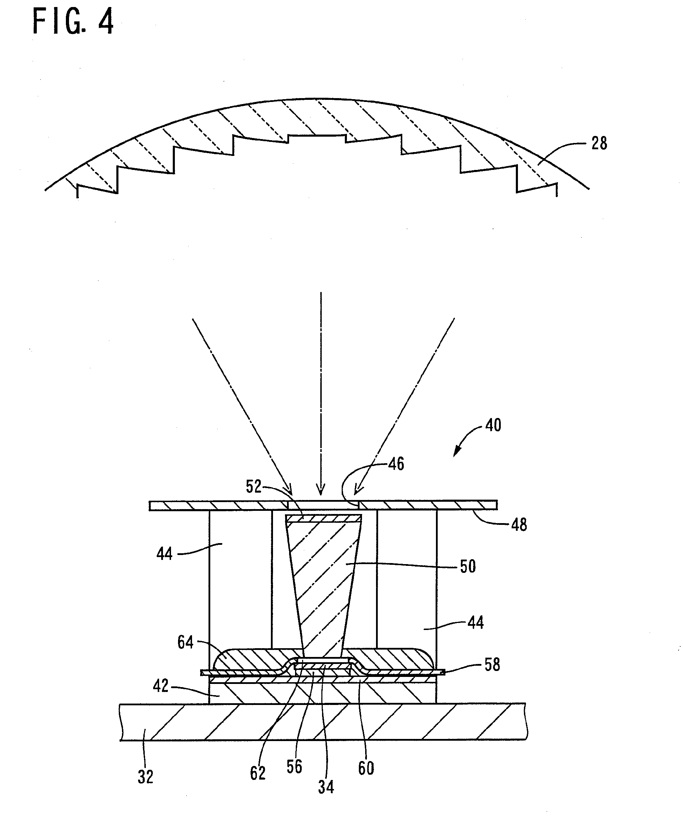

As shown in Fig. 4 each of a plurality of the above-indicated condenser lens 28 has a spherical surface on one side (or upper side), and a stepped surface that forms annularly, mutually convex and concave surface on the other side (or bottom side or back side). Such kind of the lens 28 is called a domelike Fresnel lens. The condenser lens 28 is mutually integrally constructed and formed of plastic material having superior optical characteristics such as PMMA, in a process of molding such as injection molding. The concentrator plate 30 is constructed of a plurality of the condenser lenses 28 which is thus integrally constructed, with a rectangular lens container frame 36 surrounding the lenses 28 on their peripheries.

The support plate 32 is rectangular and has substantially equal dimensions in its longitudinal and lateral directions to the above-indicated lens container frame 36. Preferably, the support plate 32 is constructed of a metal sheet of high thermal conductivity such as an aluminum alloy or a copper alloy. The support plate 32 is mutually connected with and parallel to the lens container frame 30 through connecting columns 37. Upon the support plate 32 there are disposed a plurality of (power) generation modules 40 to generate electric power by the concentrated sunlight through the condenser lenses 28, and in the receiving position of the sunlight from each of the condenser lenses 28, that is, just below the lenses 28. As shown in Fig. 4, the generation module 40 comprises a metallic base (seating plate) 42, a shielding plate 48 and a homogenizer 50 functioning as a secondary optical system or secondary optics. The base 42 is secured to the support plate 32 in abutting contact, and has the solar cell 34 disposed in the center. The shielding plate 48 is disposed and spaced by a predetermined distance above the base 42, which is supported by four columns 44 fixed on the base 42. And the shielding plate 48 has a through-hole 46 formed substantially just above the solar cell 34. The homogenizer 50 is supported by the shielding plate 48, and guides the sunlight that has passed through the through-hole 46 on the shielding plate 48, to the receiving surface on the upper surface of the solar cell 34, in which the intensity of the sunlight is homogenized.

The above-indicated shielding plate 48 is employed for transmitting only the sunlight which is concentrated through the condenser lens 28 toward the solar cell 34 for power generation, and for slowing down a rise in temperature around the solar cell 34 by shielding a light which is not available for power generation. The above-indicated homogenizer 50 has a form of a truncated pyramid in which its cross section becomes smaller as approaching the solar cell 34, that is, from a point around the through-hole 46 to the side of the solar cell 34. The homogenizer 50 homogenizes the intensity distribution of the optical energy within the cross section on the way that the sunlight travels toward the solar cell 34 with repeating internal total reflection (total reflection on the interface) on the internal surface. For instance, the homogenizer 50 has dimensions of 40 mm in height and of the same dimensions of the output surface (the surface on the side of the solar cell 34) as the surface of the solar cell 34, such as 7 mm in the longitudinal and lateral directions, to form a prism (or prismoidal) optical member.

This homogenizer is made of such as borosilicate glass having the composition of, for instance, 69 wt% of SiO₂, 9 wt% of Na₂O, 8 wt% of K₂O, 3 wt% of BaO, 10 wt% of B₂O₃ and 1 wt% of As₂O₃, and approximately 1.516 of the refractive index. An anti-reflection layer 52 is laminated on the incident surface, the upper end surface, of the homogenizer 50 to restrain reflection of light by utilization of optical interference. The anti-reflection layer 52 is constructed of a layer having a bilayer of Al₂O₃ and TiO₂, or a multilayer of TiO₂/Al₂O₃ in this embodiment, and the thickness of it is, for instance, approximately 120 nm. The anti-reflection layer 52 is deposited in a vacuum evaporation method in this embodiment.

The above-indicated solar cell 34 is constructed on a chip which has, for instance, well-known InGaP/InGaAs/Ge structure caused by crystal growth of the compound semiconductor of groups III-V on a single crystal substrate such as GaAs. The solar cell 34 has a multi-junction structure in which a plurality of kinds of p-n junctions respectively having a different absorption wavelength band. For example, the multi-junction structure comprises a bottom junction layer, intermediate junction layer and upper junction layer which are successively laminated. The p-n junctions are respectively formed in the bottom, intermediate and upper junction layers, and are electrically connected in series and provided with absorption wavelength bands which have a different center wavelength. Consequently, the above-indicated structure provides higher conversion efficiency due to wide absorption wavelength band in the wavelength band of the sunlight, for instance, due to absorption of the upper junction layer ranging from 300 to 630 nm, absorption of the intermediate junction layer ranging from 630 to 900 nm, and absorption of the upper junction layer ranging from 900 to 1700 nm.

As shown in Fig. 4, the solar cell 34 comprises a first lead electrode 56 and a second lead electrode 58. The first lead electrode is a tape- or ribbon-like a metal plate which is soldered at the whole bottom surface. The second lead electrode 58 is tape-like and soldered to the upper surface of the first lead electrode 56 at its end portion. The solar cell 34 is fixed on a bonding layer 60 at least at a portion, preferably, at the whole bottom surface as the whole portion is embedded, and consequently, the solar cell 34 is fixed on the base 42 in the center. The bonding layer 60 is formed of synthetic plastic sheet in which filler for increasing thermal conductivity including at least one of carbon, glass fiber, alumina (Al₂O₃) powder, and metallic powder is dispersed. The solar cells 34 are each other connected in series through the first and second lead electrodes 56 and 58 so that high voltage can be output.

Between the bottom surface of the above-indicated homogenizer 50 and the solar cell 34 that is opposingly disposed to the homogenizer 50 there is a narrow space. And this intervening narrow space is filled with transparent resin to form a transparent resin member 62 in order to avoid entering of moisture. For the transparent resin member 62, material of high heat resistance and superior optical characteristics such as silicone gel is employed.

In order to prevent from deterioration of the above-indicated transparent resin member 62, a bottom portion of the homogenizer 50 and members placed below it including the solar cell 34 is coated with a non-transparent colored resin member such as white resin member 64, the white resin member 64 is bonded to and covers them with sufficient thickness of resin. The white resin member 64 functions as a shielding member, and includes filler within a self-adhesive RTV silicone resin to increase the effects of shielding from and reflection of sunlight. For the filler is employed inorganic material such as calcium carbonate, titanium oxide, high purity alumina, high purity magnesium oxide, beryllium oxide, silica and/or aluminum nitride in a state of white and non-transparent powder. The above-indicated self-adhesive RTV silicone resin or rubber as a base resin includes an adhesive assistant such as silane coupling agent to increase adhesive properties, and, further, not less than 10 wt% of fluorosilicone resin having a low moisture permeation characteristic. This low moisture permeation characteristic of fluorosilicone resin restrains entering of moisture. The white resin member 64 functions as a sealing resin member for sealing to avoid entering of moisture.

The low moisture permeation characteristic is indicated by a moisture permeability rate. The white resin member 64 has the moisture permeability rate of not more than 50 (g/m² ·24h) to rerstrain entering of moisture so that lowering of the generation efficiency of the power module 40 is restrained to obtain high durability. The above-identified moisture permeation rate is indicated by a value measured at the temperature of 40°C in the Moisture Permeation Test Method of Moisture Proof Packaging Material (Cup Method) in accordance with JIS Z0208 of the Japanese Industrial Standards in this embodiment.

The base 42 having solar cell 34 in the center is coated with the white resin member 64 in a fluid state, for instance, in not more than 50 Pa·s of viscosity. Then a depressurized container contains the coated base 42 and a discharge of a solvent and deaeration is performed under the pressure of not more than 3 mmHg for not less than 60 seconds. And the coated members including the base 42 are processed in thermal hardening process at a predetermined temperature for hardening. Narrow spaces among the first lead electrode 56, the second lead electrode 58, the base 42 and the solar cell 34 is filled with the white resin member 64 to avoid entering of moisture by the negative pressure (or vacuum) deareration of the coated members.

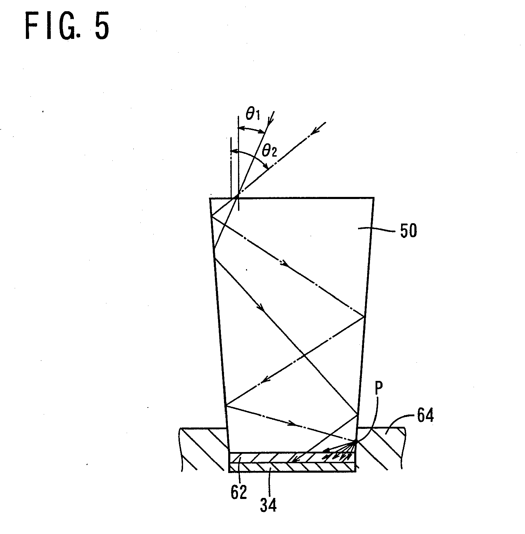

The sun tracking apparatus 12 moves the thus-constructed concentrator solar photovoltaic power generating apparatus 10 to maintain the position so that the axis of incidence of the sunlight is always substantially perpendicular to the light receiving surface. Consequently, the concentrated sunlight by the condenser lens 28 travels through the through-hole 46 opened in the center of the shielding plate 48 and at the concentrated point of the concentrated sunlight. Then, the sunlight travels through the thin layer 54 and the anti-reflection layer 52 and enters the homogenizer 50 at the upper end portion at an incident angle θ₁. In the homogenizer 50 the light repeatedly travels and is reflected off side surfaces, that is, the light repeats total reflection on the side surface, as shown in Fig. 5, to be mixed (homogenized), then enters the solar cell 34. Since the two-dimension distribution of the incident energy on the light receiving surface of the solar cell 34 is even, high conversion efficiency is achieved.

In this embodiment of the concentrator solar photovoltaic power generating apparatus 10, since the white resin member (shielding member) 64 to shield the transparent resin member 62 interposed between the bottom end surface of the homogenizer (columnar optical member) 50 and the solar cell 34 is provided, the bonded surface is not damaged due to deterioration of the transparent resin member 62 by light and, consequently, deterioration of the solar cell 34 due to entering moisture is restrained and high durability of the concentrator solar photovoltaic power generating apparatus 10 is achieved. Since the white resin member (shielding member) 64 is non-transparent colored resin member covering the transparent resin member 62, the white resin member 64 prevents deterioration of the transparent resin member 62 by sunlight, for the sunlight is difficult to reach the transparent resin member 62.

In this embodiment of the concentrator solar photovoltaic power generating apparatus 10, since the white resin member (shielding member) 64 is a non-transparent white resin including inorganic filler made of white and non-transparent powder, and is placed to also cover the outer circumferential surface of the bottom end portion of the homogenizer (columnar optical member) 50, the sunlight directing outwards through the outer surface in the bottom end portion of the homogenizer 50 is reflected by a plurality of times and reaches the solar cell 34, consequently, further higher generation efficiency is achieved. As shown by a dashed and dotted line in Fig. 5, even if the tracking error is especially comparatively large, the sunlight entered the homogenizer 50 at the larger incident angle θ₂ with respect to the incident surface (upper end surface), directs outwardly at a larger angle than the total reflective angle at point P in Fig. 5. However, the white resin member 64 causes inwardly diffuse reflection of the light, and consequently, the above-indicated effect is remarkably achieved. Ordinarily, the efficiency is 27% if the tracking error is 0°. The generation of the tracking error of 0.5° decreases the efficiency to 25.5%, and covering the bottom end portion of the homogenizer 50 with the white resin member 64 increases the efficiency to 26.2%.

In this embodiment of the concentrator solar photovoltaic power generating apparatus 10, since the light receiving surface of the solar cell 34 is provided with the anti-reflection layer 52 of a bilayer or multilayer of TiO₂/Al₂O₃ and the anti-reflection layer 52 is constituted of a material without deliquescence, further high durability of the concentrator solar photovoltaic power generating apparatus 10 is achieved.

### Embodiment 2

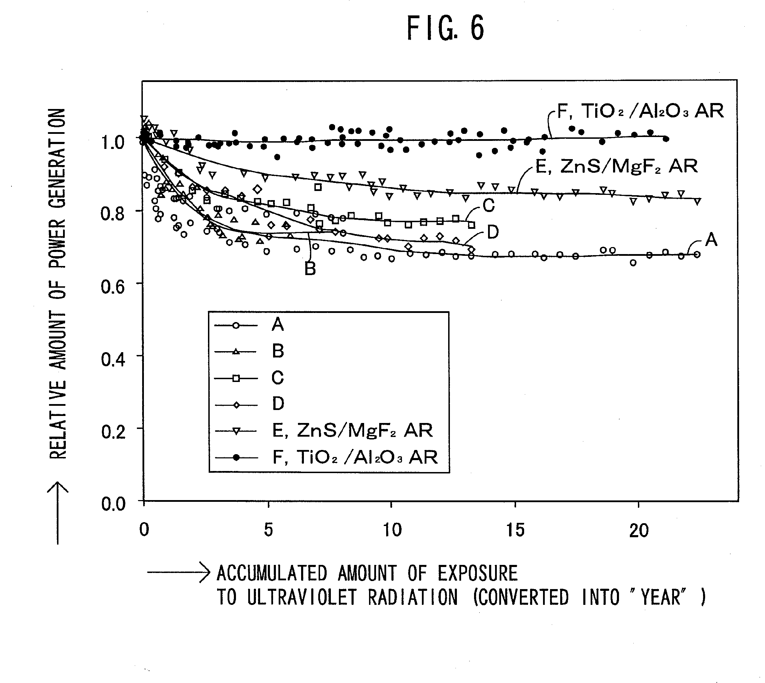

Fig. 6, 7 and 8 illustrate results of durability tests by the inventors. Fig. 6 illustrates changes in relative amounts of power generation that were measured under concentrated ultraviolet radiation corresponding to the accumulated amount for exposure for the not less than 20-year equivalence in the positively or intentionally induced dew formation environment at the temperature of 20°C by water cooling, with respect to a generation module F provided with the same white resin member 64 and the anti-reflection layer (TiO₂/Al₂O₃) 52 as in the above-described embodiment, a generation module E with the anti-reflection layer 52 of which the material is replaced by ZnS/MgF₂, the only difference between the module F and E, and generation modules A, B, C and D with transparent silicone resin member by which the white resin member 64 in the module F is replaced. It was found that the relative generation amount of the generation module A with the transparent silicone resin member in spite of the white resin member 64 was mostly decreased. In contrast, the relative generation amounts of the generation modules E and F with the white resin member 64 were decreased in a relatively small amount each. Especially, it was found that the relative generation amount of the generation module F with the white resin member 64 and the anti-reflection layer (TiO₂/Al₂O₃) 52 was almost not reduced.

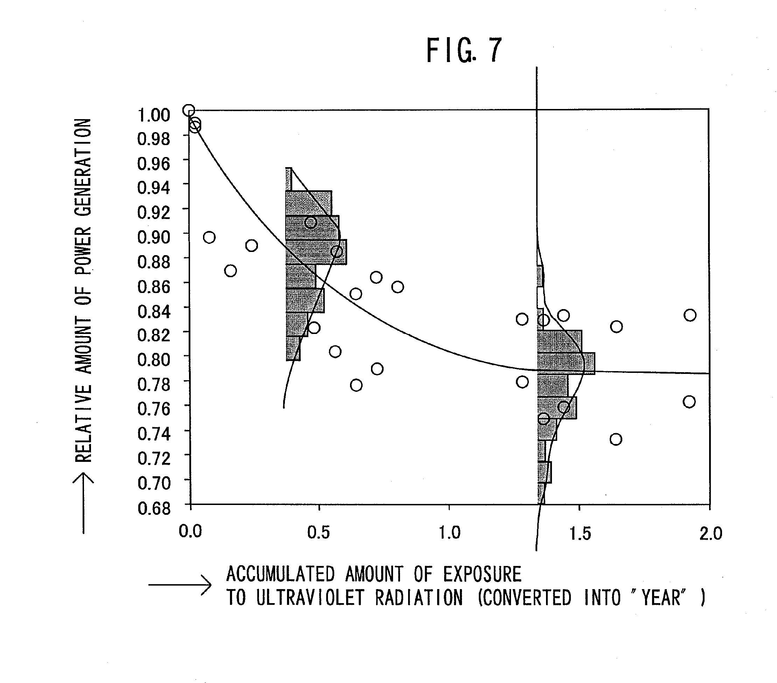

Fig. 7 illustrates characteristics of reduction in the relative generation amounts measured of the solar cells that were removed from a plurality of generation modules (equivalent to the above-indicated generation module A) in which the solar cell and the transparent resin member is sealed with a conventional silicone resin member, after exposed to the outdoor for four months. It was found the equivalent result to the test using the concentrated ultraviolet radiation in Fig. 6 in the deterioration speed.

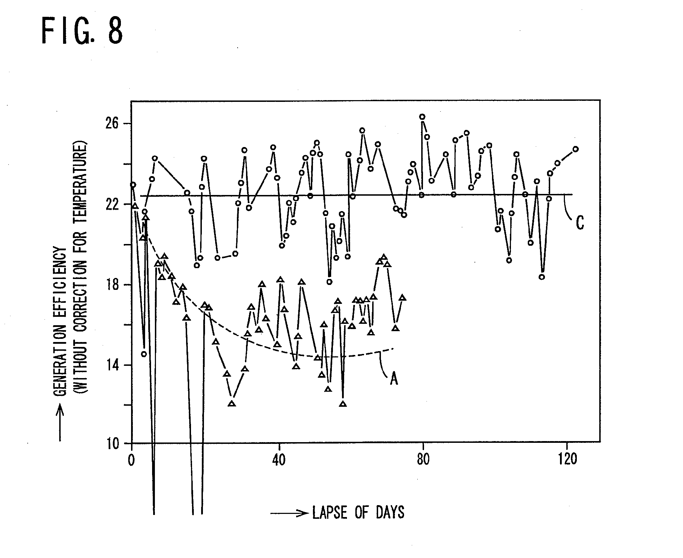

Fig. 8 illustrates the result of the field test in the outdoor using a plurality of the generation modules A in which the solar cell and the transparent resin member is sealed with a conventional silicone resin member, and the generation module C provided with the white resin member 64 and anti-reflection layer 52 equivalent to those in the above-described embodiment. The generation output of the generation module A decreased by 20% in a few months, however, that of the generation module C was maintained at a high level over a long period of time.

### Embodiment 3

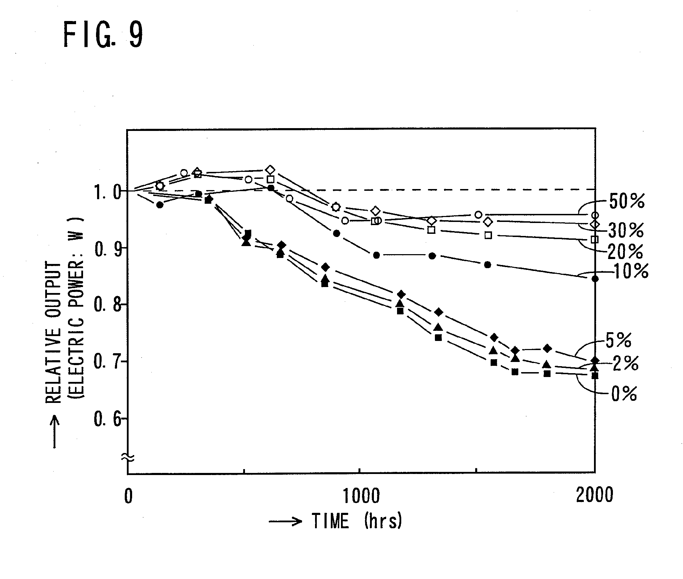

Fig. 9 illustrates the results measured of an accelerating environment test by the inventors for durability. After prepared samples of 0 wt%, 2 wt%, 5 wt%, 10 wt%, 20 wt%, 30 wt% and 50 wt% of the rate of fluorosilicone resin mixed into the white resin member 64 in the generation module 40 constructed as described above, those generation module samples were placed in an accelerating environment test tank maintained at the temperature of 85°C and the relative humidity of 85%. Outputs from the generation module samples were measured at every predetermined time (or day).

In Fig. 9 the longitudinal axis shows the relative output value to the initial generation output value that was regarded as 1, and lateral axis shows the elapsed time. The effect for 2000 hours in the above accelerating environment test corresponds to that for six years in the outdoor. In general it is regarded as practically effective if the relative output of not less than 70% is maintained, that is, not more than 30% of deterioration is observed, after 2000 hours has elapsed. As apparent from Fig. 9, although the comparative generation module samples of 0 wt%, 2 wt% and 5 wt% of the rate of fluorosilicone resin mixed into the white resin member 64 were not practically effective, the generation module samples of 10 wt%, 20 wt%, 30 wt% and 50 wt% of the rate of fluorosilicone resin according to the present embodiment were practically effective.

### Embodiment 4

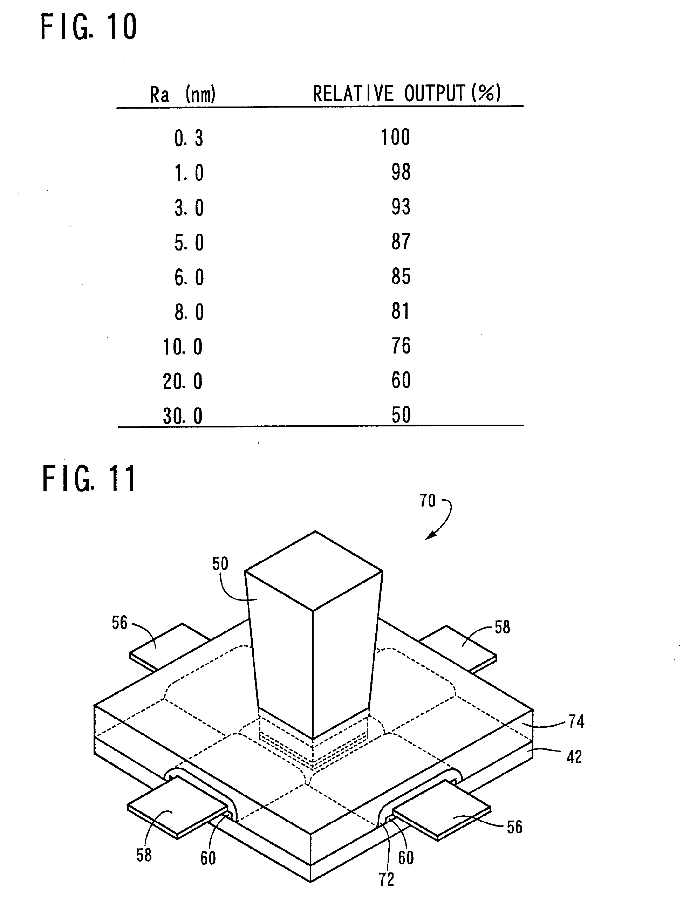

In this experiment, the respective output was measured from the prepared nine kinds of generation module samples which had the equivalent structure to those in the above-described embodiment, other than that the homogenizer 50 made of borosilicate glass has nine kinds of surface roughness Ra ranging from 0.3 nm to 30 nm in the generation modules 40 constituted as described above. Fig. 10 illustrates a table showing the result of measurement, the relationship between the surface roughness Ra and generation outputs of the generation module samples. The generation outputs shown in Fig. 10 are relative values to the generation module sample of surface roughness Ra of 0.3 nm that is regarded as 100.

As shown in Fig. 10, the generation output is reduced as the surface roughness Ra becomes larger. The generation output is not less than 81 % with the surface roughness Ra of not larger than 8 nm, the output is below 80% with the roughness Ra over 10 nm, and the output is approximately 50% with the roughness Ra of 30 nm. Less sufficiency in polishing the surface causes larger surface roughness Ra and leakage of light, and consequently, the decrease in generation efficiency.

In the above-described embodiments 1-4 of the generation module 40 of the concentrator solar photovoltaic power generating apparatus 10, since the white resin member 64 that covers the bottom portion of the homogenizer 50 and the solar cell 34 that is disposed as opposed to the bottom surface of the homogenizer 50, includes not less than 10 wt% of fluorosilicone resin, the low moisture permeation characteristic of fluorosilicone resin restrains entering of water vapor (or moisture), and consequently, it causes high durability and low deterioration in generation efficiency.

In the embodiments of the generation module 40 of the concentrator solar photovoltaic power generating apparatus 10, since the white resin member 64 has the permeability rate of not more than 50 g/m² ·24h, entering of water vapor (or moisture) is restrained, and consequently, it is provided with the generation module 40 of the concentrator solar photovoltaic power generating apparatus with high durability and low deterioration in its generation efficiency.

In the embodiments of the generation module 40 of the concentrator solar photovoltaic power generating apparatus 10, since the transparent resin member 62 is interposed between the bottom end surface of the homogenizer 50 and the solar cell 34, and the white resin member 64 is constituted of non-transparent and colored silicone resin including filler, the solar cell 34 is shielded and preferably protected from the external light.

In the embodiments of the generation module 40 of the concentrator solar photovoltaic power generating apparatus 10, since the homogenizer 50 is made of superior waterproof borosilicate glass, a little amount of sodium component in the homogenizer 50 is eluted upon reaching of water vapor on the surface of the homogenizer 50, and consequently, it causes high durability and low deterioration in generation efficiency.

In the embodiments of the generation module 40 of the concentrator solar photovoltaic power generating apparatus 10, since the glass of which the homogenizer 50 is constituted has the surface roughness Ra (arithmatic averaged roughness) of not larger than 10 nm, reflection factor of the internal side surface is high, and consequently, it causes high generation efficiency as the result of restraining leakage of light.

### Embodiment 5

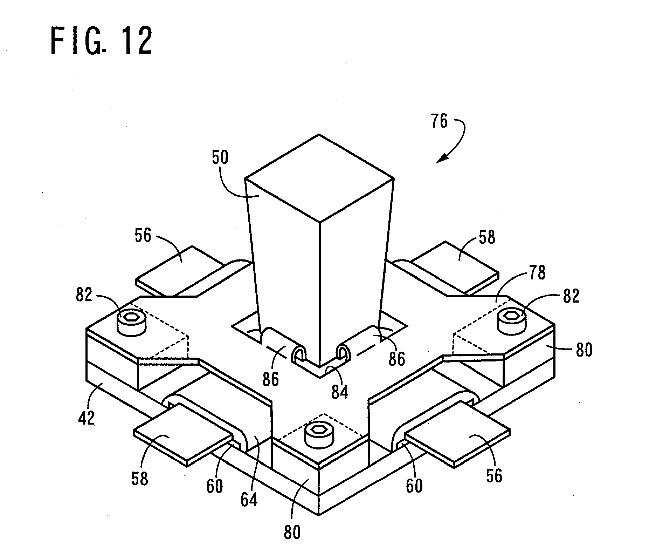

Figs. 11 and 12 illustrate structures of generation modules of other embodiments according to the present invention. The same reference number as that in the embodiments described above are given for the equivalence and the description for it is omitted in the following descriptions.

Figs. 11 and 12 illustrate other generation modules in which the bottom end portion of the homogenizer 50 is supported, and the modules is not provided with the shielding plate 48 to support the upper end portion of the homogenizer 50 and four columns to support the shielding plate 48.

In Fig. 11 the generation module 70 is provided with the solar cell 34, the homogenizer 50, the first and second lead electrodes 56 and 58, the transparent resin member 62 and the white resin member 72 on the base 42, as well as the generation module 40. This module 70 is different from the module 40 in a few points as follows. In the module 70 of this embodiment, as well as the white resin member 64 the white resin member 72 is constituted of hard silicone resin including inorganic filler, as well as the white resin member 64 of the module 40 the white resin member 72 covers the transparent resin member 62 and is filled with narrow spaces among the first and second lead electrodes 56 and 58, the base 42 and the solar cell 34. And the bottom end portion of the homogenizer 50 is covered with a building of the white resin member 72 constituted of the hard silicone resin and fixed. Then on the base 42 is comparatively thickly covered with the white resin member 74 constituted of soft silicone resin and including equivalent inorganic filler for waterproofing. In this embodiment the white resin members 72 and 74 function as the shielding members. Since the refractive index of the above white resin member 72 is approximately 1.42 and that of the homogenizer 50 is approximately 1.59, an incident ray at a shallow angle (≥ 64°) is totally reflected off an interface, and an incident ray at a deep angle (< 64 °) is diffused at an interface due to the white resin member 72 and a portion of the ray enters the solar cell 34, consequently, further high generation efficiency is provided. Although the white resin member 72 constituted of the hard silicone resin has no superior characteristic for waterproofing, the white resin member 74 constituted of the soft silicone resin which has superior characteristic for waterproofing is employed for superior waterproofing.

### Embodiment 6

In Fig. 12 the generation module 76 is provided with the solar cell 34, the homogenizer 50, the first and second lead electrodes 56 and 58, the transparent resin member 62 and the white resin member 64 on the base 42, as well as the generation module 40. This module 76 is different from the module 40 in a point that the bottom end portion of the homogenizer 50 is fixed by a support plate 78. The support plate 78 is fixed by bolts 82 at the four corners of the base 42 with spacers 80 respectively interposed which are provided by a press-forming operation with a metal sheet such as a stainless steel sheet. In the center of the support plate 78, a square-shaping through-hole 84 which is sufficiently larger than the cross section of the bottom end portion of the homogenizer 50 is opened, and projections 86 are inwardly protruded from an intermediate portion of the respective side of the through-hole 84. The projections 86 are formed in a U-shaping in the press-forming operation, and they receive and support the bottom end portion of the homogenizer 50 by a spring force. In this embodiment, the white resin member 64 and the support plate 78 function as shielding members. In this embodiment, since the bottom end portion of the homogenizer 50 is fitted into the through-hole 84 and fixed with the above projections 86 being elastically deformed, facilitated assembling is achieved.

It is to be understood that the present invention may be embodied with other changes, improvements, and modifications that may occur to a person skilled in the art without departing from the scope and spirit of the invention defined in the appended claims.

## Claims

1. A concentrator solar photovoltaic power generating apparatus including a primary optics for concentrating sunlight, a solar cell, a columnar optical member which is vertically disposed above the solar cell so that a bottom end surface of the columnar optical member is opposed to the solar cell, and which is used for guiding the sunlight which is concentrated by the primary optics to the solar cell, a transparent resin member which is interposed between the bottom end surface of the columnar optical member and the solar cell, being **characterized by** comprising:
a shielding member for shielding the transparent resin member from sunlight.

2. The apparatus as defined in claim 1, being **characterized by** that the shielding member is a non-transparent colored resin member which covers the transparent resin member.

3. The apparatus as defined in claim 2, being **characterized by** that the non-transparent colored resin member is a white resin member including filler which is constituted by white and non-transparent powder, and is disposed so as to cover an outer circumferential surface of a bottom end portion of the columnar optical member.

4. The apparatus as defined in any one of claims 1-3, being **characterized by** that the solar cell is provided with an anti-reflection layer of TiO₂/Al₂O₃ at its light receiving surface.

5. The apparatus as defined in claim 1, being **characterized by** that the shielding member covers a bottom end portion of the columnar optical member and the solar cell which is opposed to a bottom end surface of the columnar optical member, and includes not less than 10 wt% of fluorosilicone resin.

6. The apparatus as defined in claim 5, being **characterized by** that the shielding member includes not more than 50 wt% of fluorosilicone resin.

7. The apparatus as defined in any one of claims 1-6, being **characterized by** that the shielding member has a permeability rate of not more than 50 g/m² ·24h.

8. The apparatus as defined in any one of claims 1-8, being **characterized by that** the transparent resin member is interposed between the bottom end surface of the columnar optical member and the solar cell, and the shielding member is constituted by a non-transparent colored silicone resin member including filler.

9. The apparatus as defined in any one of claims 1-8, being **characterized by** that the columnar optical member is constituted by borosilicate glass.

10. The apparatus as defined in any one of claims 1-9, being **characterized by** that glass which constitutes the columnar optical member has not larger than 10 nm of the surface roughness Ra (arithmetic averaged roughness).
